Europäisches Patentamt

European Patent Office

Office européen des brevets

(11) Veröffentlichungsnummer: **0 261 464**
**A2**

## (12) EUROPÄISCHE PATENTANMELDUNG

(21) Anmeldenummer: 87112836.9

(22) Anmeldetag: 02.09.87

(51) Int. Cl.4: **H04N 5/30** , H04N 5/335

(30) Priorität: 26.09.86 DE 3632804

(43) Veröffentlichungstag der Anmeldung:
30.03.88 Patentblatt 88/13

(84) Benannte Vertragsstaaten:
DE FR GB IT NL

(71) Anmelder: **Siemens Aktiengesellschaft Berlin
und München**
**Wittelsbacherplatz 2**
**D-8000 München 2(DE)**

(72) Erfinder: **Herbst, Heiner, Dr.**
**Anechostrasse 29a**
**D-8000 München 82(DE)**

(54) **Verfahren zum Betrieb eines Halbleiter-Bildsensors für eine elektronische Kamera mit automatischer Belichtungsregelung.**

(57) Ein Verfahren zum Betrieb eines Halbleiter-Bildsensors für eine elektronische Kamera mit automatischer Belichtungsregelung, bei dem die Betriebsspannung ($U_{ITO}$) für den Bildsensor derart getaktet wird, daß sie nur für einen Anteil ($\alpha$) der maximalen Integrationszeit ($T_0$) anliegt, so daß die effektive Integrationszeit an die Szenenhelligkeit anpaßbar ist, wobei der Anteil ($\alpha$) ein langsam mit der Zeit zwischen praktisch O und 1 variierender Faktor ist, dessen Größe über eine Regelung von der Helligkeit der aufzunehmenden Szene abhängt, und wobei die effektive Belichtungszeit ($T_{eff}$) durch die Beziehung $T_{eff} = \alpha T_0$ gegeben ist.

# FIG 1

EP 0 261 464 A2

## Verfahren zum Betrieb eines Halbleiter-Bildsensors für eine elektronische Kamera mit automatischer Belichtungsregelung

Die vorliegende Erfindung betrifft ein Verfahren zum Betrieb eines Halbleiter-Bildsensors für eine elektronische Kamera mit automatischer Belichtungsregelung, insbesondere zum Betrieb eines MOS-Bildsensors.

In der Videotechnik werden in zunehmendem Maße elektronische Kameras mit Halbleiter-Bildsensoren bestückt. Sie zeichnen sich gegenüber Röhrenkameras durch geringes Gewicht, geringen Leistungsverbrauch und größere Lebensdauer aus. Die Vorteile der Halbleiter-Bildsensoren können noch vergrößert werden, wenn es gelingt, eine vollelektronische automatische Belichtungsregelung durchzuführen. Bekannt sind bisher elektromechanische Regelungen der Blende. Diese Verfahren sind jedoch verhältnismäßig aufwendig und störungsanfällig im Betrieb.

In der DE-PS 2 810 806 sind Verfahren zur elektronischen Steuerung und Regelung der Belichtungszeit (Integrationszeit) von CCD-und CID-Bildsensoren beschrieben. Diese Verfahren können jedoch nicht auf MOS-Sensoren mit Photodioden oder Photoleiterschicht angewendet werden.

Für derartige Bauelemente werden in der DE-OS 31 38 240 und DE-OS 31 38 294 brauchbare Verfahren angegeben.

Diese Verfahren erfordern jedoch zusätzliche Schaltungen auf dem Chip und ein komplizierteres Taktdiagramm in der Ansteuerung.

Die Aufgabe der vorliegenden Erfindung besteht darin, ein gegenüber dem Stand der Technik einfacheres Verfahren zum Betrieb von Bildsensoren mit Photoleiterschicht, wie z. B. amorphem Silizium, zu schaffen, das keine aufwendige Schaltungstechnik benötigt.

Die der vorliegenden Erfindung zugrundeliegende Aufgabe wird durch ein Verfahren der eingangs genannten Art und gemäß dem Oberbegriff des Patentanspruchs 1 gelöst, das durch die in dem kennzeichnenden Teil des Patentanspruchs 1 angegebenen Merkmale charakterisiert ist.

Im folgenden wird die Erfindung anhand einiger Figuren beschrieben.

Fig. 1 zeigt einen Schichtaufbau eines Detektorelements mit amorphem Silizium (Photoleiter).

Fig. 2 zeigt ein Ersatzschaltbild des Detektorelements gemäß Fig. 1.

Fig. 3 zeigt ein Kennliniendiagramm des Photostroms über der Spannung an dem Photoleiter.

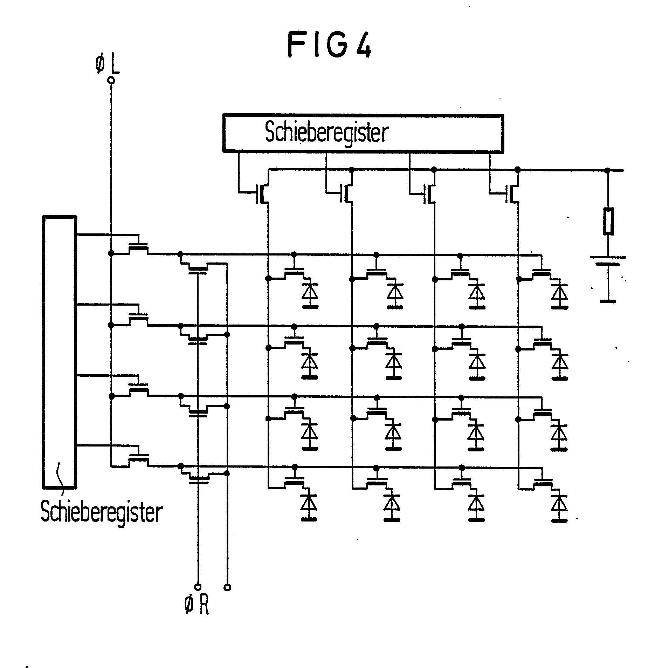

Fig. 4 zeigt das Prinzipschaltbild eines MOS-Bildsensors.

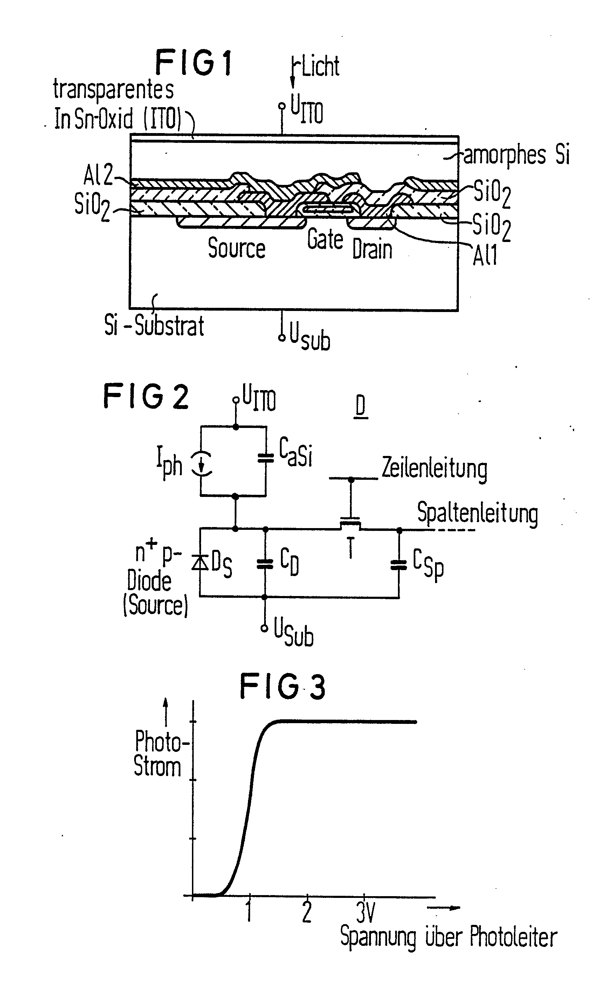

Der Erfindung liegt die Erkenntnis zugrunde, daß der Photostrom $I_{ph}$ (Fig. 2) durch die Photoleiterschicht unterhalb einer bestimmten Spannung von der Spannung selbst abhängig ist und bei O V verschwindet (Fig. 3). Im letzten Fall werden die optisch erzeugten Elektron-Loch-Paare nicht mehr in einem elektrischen Feld getrennt und rekombinieren wieder. Wird also die Spannung $U_{ITO}$ (Fig. 1 und Fig. 2) so getaktet, daß sie nur für einen bestimmten Teil $\alpha$ der maximalen Integrationszeit $T_0$ in den aktiven Zustand geschaltet wird, so kann die effektive Integrationszeit an die Szenenhelligkeit angepaßt werden. Dabei ist $\alpha$ eine langsam mit der Zeit zwischen nahezu 0 und 1 variierende Größe, die über eine Regelung von der Helligkeit der aufzunehmenden Szene ab hängt. Die effektive Belichtungszeit ist dann $T_{eff} = \alpha T_0$.

Fig. 1 und Fig. 2 zeigen, daß der Photoleiter an die Source-Elektrode eines Auslesetransistors angeschlossen ist. Nach dem Auslesen der Signalelektronen liegt das Source-Gebiet auf einem Potential, das von dem Potential auf der Spaltenleitung und der Höhe des Pulses auf der Zeilenleitung abhängt. In MOS-Bildsensoren mit üblichen Technologieparametern kann dieses Rücksetzpotential etwa 4 V betragen. Auf der anderen Seite darf das Source-Potential nie so weit negativ werden, daß der Auslesetransistor öffnet oder die Source-Diode gegenüber dem Substrat in Durchlaßrichtung geht. Üblicherweise sind diese Bedingungen erfüllt, wenn das Source-Potential nicht kleiner als etwa O V wird. Die ITO-Schicht (Fig. 1) kann demnach auf ein Potential zwischen 4 und O V gelegt werden. Bei O V ist der Photoleiter aktiv, bei 3-4 V inaktiv. Zwischen diesen Grenzen sollte die ITO-Spannung gepulst werden

Dieses Verfahren zur Belichtungszeitregelung kann bei MOS-Sensoren und bei CCD-und BBD-Sensoren nach dem sog. Zwischenzeilen (Interline) - Prinzip angewendet werden, sofern sie einen Detektoraufbau entsprechend Fig. 1 haben. Die ITO-Takte werden synchron zur Vertikalaustastlücke angelegt. Bei MOS-Sensoren kann es jedoch stören, daß für jede Zeile eine individuelle Integrationsperiode gilt, die um eine Zeilendauer (64 µs) gegenüber der der Nachbarzeile verschoben ist. Aus diesem Grund ist es vorteilhaft, die ITO-Takte synchron zur Horizontalaustastlücke anzulegen.

Die Einstellung von $\alpha$ entsprechend der Szenenhelligkeit kann analog zu den in den DE-OS'n 31 38 240 und 31 38 294 offenbarten Verfahren erfolgen.

Es ist ersichtlich, daß das vorgeschlagene Verfahren durch den Fachmann sinngemäß auf Anordnungen mit anderen Photoleitern, Elektrodenmaterialien und Auslesematrizen übertragen werden kann.

## Ansprüche

1. Verfahren zum Betrieb eines Halbleiter-Bildsensors für eine elektronische Kamera mit automatischer Belichtungsregelung, dadurch **gekennzeichnet,** daß die Betriebsspannung ($U_{ITO}$) für den Bildsensor derart getaktet wird, daß sie nur für einen Anteil ($\alpha$) der maximalen Integrationszeit ($T_0$) anliegt, so daß die effektive Integrationszeit an die Szenenhelligkeit anpaßbar ist, wobei der Anteil ($\alpha$) ein langsam mit der Zeit zwischen praktisch O und 1 variierender Faktor ist, dessen Größe über eine Regelung von der Helligkeit der aufzunehmenden Szene abhängt, und wobei die effektive Belichtungszeit ($T_{eff}$) durch die Beziehung $T_{eff} = \alpha T_0$ gegeben ist.

2. Verfahren nach Anspruch 1, dadurch **gekennzeichnet,** daß das Source-Potential des einem Detektorelement (D) individuell zugeordneten Auslesetransistors (T) dadurch an einem Absinken in den negativen Bereich - wodurch eine ebenfalls je Detektorelement (D) individuell vorgesehene Source-Diode ($D_S$) in Durchlaßrichtung vorgespannt würde-gehindert wird, daß das Source-Potential auf einem Wert nicht kleiner als ca. O V und die an die Betriebsspannung ($U_{ITO}$) gelegte transparente In-Sn-Oxid-Schicht des Bildsensors auf einem Potential zwischen 4 V und O V während des Taktens gehalten wird.

3. Verfahren nach Anspruch 1 oder 2, dadurch **gekennzeichnet,** daß die Takte synchron mit der Vertikalaustastlücke angelegt werden.

4. Verfahren nach Anspruch 1 oder 2, dadurch **gekennzeichnet,** daß die Takte synchron mit der Horizontalaustastlücke angelegt werden.

# FIG 1

Licht

$U_{ITO}$

transparentes
In Sn-Oxid (ITO)

amorphes Si

Al2
$SiO_2$

$SiO_2$
$SiO_2$
Al1

Source     Gate  Drain

Si -Substrat

$U_{sub}$

# FIG 2

$U_{ITO}$

$\underline{D}$

$I_{ph}$    $C_{aSi}$

Zeilenleitung

Spaltenleitung

T

$n^+$ p-
Diode
(Source)

$D_S$   $C_D$        $C_{Sp}$

$U_{sub}$

# FIG 3

Photo-
Strom

1     2     3V

Spannung über Photoleiter

# F I G 4